Europäisches Patentamt

European Patent Office

Office européen des brevets

(19)

(11) Veröffentlichungsnummer: **0 265 582**
**A1**

## (12) EUROPÄISCHE PATENTANMELDUNG

(21) Anmeldenummer: 87105443.3

(22) Anmeldetag: 13.04.87

(51) Int. Cl.⁴: **H 01 L 35/34,** H 01 L 35/02,
G 01 K 7/04

(30) Priorität: 25.10.86 DE 3636468

(43) Veröffentlichungstag der Anmeldung: 04.05.88
Patentblatt 88/18

(84) Benannte Vertragsstaaten: DE FR GB IT NL SE

(71) Anmelder: W.C. Heraeus GmbH, Heraeusstrasse 12 - 14,
D-6450 Hanau / Main (DE)

(72) Erfinder: Thom, Manfred, Am Heinichenberg 50,
D-6454 Bruchköbel (DE)
Erfinder: Kohl, Wolfgang, Dr., Wolfgangstrasse 48,
D-6458 Rodenbach 1 (DE)

(74) Vertreter: Heinen, Gerhard, Dr., Heraeus Holding GmbH
Heraeusstrasse 12-14, D-6450 Hanau am Main (DE)

(54) **Manteldrahtthermoelement.**

(57) Die Erfindung betrifft ein Verfahren zur Herstellung eines Halbzeuges für Mantelthermoelemente mit mindestens zwei ein Thermoelement bildenden Metalldrähten (2, 3), wobei der eine Draht ein reiner Platindraht (2) und der andere Draht (3) ein Platin-Rhodium-Draht ist, die jeweils in eine Kapillare in einem Keramikkörper (1) eingeführt werden. Es wird ein Verfahren angegeben, mit dem es möglich ist, ein Halbzeug für Mantelthermoelemente mit Thermodrähten aus reinem Platin und Platin-Rhodium herzustellen mit einem Außendurchmesser, der im Bereich von 0,3 mm liegt. Gemäß diesem Verfahren werden als Metalldrähte (2, 3) Drähte mit annähernd gleicher Umformfestigkeit bereitgestellt und ein Metallrohr (4) mit einer mindestens 1,5fach höheren Umformfestigkeit als die der Metalldrähte (2, 3) verwendet, anschließend das Metallrohr (4) mit dem eingesetzten, die Drähte aufweisenden Keramikkörper (1) unter Erwärmen auf eine Temperatur bis zu 400 °C evakuiert, verschlossen und über das Metallrohr (4) ein Hüllrohr (5) gestülpt, dessen Umformfestigkeit beim Anliegen am Metallrohr (4) im Bereich derjenigen des Metallrohres (4) liegt und anschließend die so gebildete Anordnung im Einzelzug in mehreren Schritten und Endmaß kalt umgeformt und danach das Hüllrohr (5) entfernt.

W. C. Heraeus GmbH, Hanau

Patent- und Gebrauchsmusterhilfsanmeldung

"Manteldrahtthermoelement"

Die vorliegende Erfindung betrifft ein Verfahren zur Herstellung eines Halbzeuges für Mantelthermoelemente mit mindestens zwei ein Thermoelement bildenden Metalldrähten, wobei der eine Draht ein reiner Platindraht Reinheitsgrad
99,99 %) und der andere Draht ein Platin-Rhodium-Draht ist, die jeweils in
eine Kapillare in einem Keramikkörper eingeführt werden, danach der Keramikkörper in ein Metallrohr gesteckt und diese Anordnung einer vorgegebenen Anzahl von Zieh- und/oder Gesenkschmiede-Schritten unterworfen wird. Derartige
Verfahren sind allgemein bekannt.

Des weiteren betrifft die Erfindung ein Halbzeug für ein Mantelthermoelement
mit einem Keramikkörper, der zwei Kapillaren mit darin eingesetzten Thermoelement-Drähten, wobei der eine Draht aus reinem Platin und der andere Draht
der Platin-Rhodium-Draht ist und mit einem den Keramikkörper umgebenden
Metallrohr.

Als Mantelthermoelement wird ein Temperaturfühler bezeichnet, der zwei, als
Thermopaar geeignete Drähte, auch Seelen genannt, aufweist, die an einem Ende
miteinander verschweißt und ansonsten durch eine Keramik voneinander isoliert
sind. Diese wiederum ist von einem metallischen Mantel umgeben.

Bei der Herstellung von Mantel-Thermoelementen wird von einem Keramikrohr
(z. B. Magnesium-Oxid) mit zwei Kapillaren ausgegangen. In die Kapillaren
werden die für die Herstellung eines Thermoelementes notwendigen Thermodrähte,
z. B. Pt-PtRh, Ni-NiCr, eingefädelt. Das Keramikrohr wird in ein Rohr, z. B.

aus PtRhl0 oder Inconel (= reg. Wz. Fa. Inco) eingeschoben. Der gesamte Verbund wird dann durch Hämmern (gleichmäßig von allen Seiten, so daß die Geometrie erhalten bleibt) und Ziehen auf das gewünschte Maß umgeformt.

Im Gegensatz zu den metallischen Partnern des Verbundes kann die Keramik nicht plastisch umgeformt werden. Sie zerbricht bei der Umformung und umschließt die Seelen dann als feinkörniges Pulver. Daher wird meist eine feinkörnige Keramik benutzt, die bis zu etwa 95 % der theoretisch möglichen Dichte verdichtet ist.

Die Wirkung des Ziehsteines wird vom Mantel über die Keramik auf die Seelen übertragen. Während der Mantel Zugspannungen durch die Art der Umformung und Reibspannungen durch die Berührung mit dem Ziehkanal erfährt, erfahren die Seelen die Spannungen nur über die Keramikpartikeln, die selber nicht fließfähig sind. Weiterhin sind die Seelen nicht zentrisch angeordnet, d. h. die Spannungen zum Mantel und zum Kern hin sind unterschiedlich, so daß die Seelen ihre Geometrie verlieren und brechen. Dies ist insbesondere dann der Fall, wenn Thermoelemente mit sehr kleinem Durchmesser, d. h. mit einem Durchmesser kleiner als 0,4, insbesondere 0,25 mm Außendurchmesser, angestrebt werden.

Mantelthermoelemente werden allgemein in VDI-Berichte Nr. 112, 1966, Seite 95 ff. (DK 536.532-213.3) unter der Überschrift "Mantel-Thermoelemente" von Ing. T. Sannes, Eindhoven (Niederl.) beschrieben. In diesem Bericht ist ausgeführt, daß zum Einsatz in der Nukleartechnik bereits Mantel-Thermoelemente mit nur 0,34 mm Außendurchmesser und flachgewalztem Meßstellenende verwendet wurden, allerdings nicht für Thermoelemente mit Platin - Platin/Rhodium 10 Thermodrähten, da diese für den Einsatz in der Reaktortechnik nicht geeignet sind.

Des weiteren sind Mantelthermoelemente in "elektrotechnik" 52, H. 4, 18.02.70, Seiten 16 und 17 unter der Überschrift "Thermoelemente miniaturisiert und gut bewehrt" beschrieben. Im diesem Aufsatz ist hervorgehoben, daß im Hinblick auf kleine Durchmesser ein Trend zu Chromel-Alumel als Material für Thermodrähte führt, da dieses Material günstigere Eigenschaften aufweist und mit ihm kleine Abmessungen (Außendurchmesser bis herab auf 0,25 mm) erreichbar sind. Erreichbare Durchmesser für Platin-, Platin-Rhodium-Thermopaare sowie deren Herstellungsverfahren sind, obwohl diese Thermopaar-Kombination erwähnt ist, diesem Aufsatz nicht zu entnehmen.

...

Der vorliegenden Erfindung liegt die Aufgabe zugrunde, ein Verfahren oder Verfahrensschritte sowie ein Halbzeug anzugeben, mit denen es möglich ist, ein Halbzeug für Mantelthermoelemente mit Thermodrähten aus reinem Platin und Platin-Rhodium herzustellen mit einem Außendurchmesser, der im Bereich von 0,3 mm liegt.

Diese Aufgabe wird dadurch gelöst, daß als Metalldrähte Drähte mit annähernd gleicher Umformfestigkeit bereitgestellt werden und ein Metallrohr mit einer mindestens 1,5-fach höheren Umformfestigkeit als die der Metalldrähte verwendet wird, daß das Metallrohr mit dem eingesetzten die Drähte aufweisenden Keramikkörper unter Erwärmen auf eine Temperatur bis zu 400 °C evakuiert, verschlossen und über das Metallrohr ein Hüllrohr gestülpt wird, dessen Umformfestigkeit beim Anliegen am Metallrohr im Bereich derjenigen des Metallrohres liegt, daß die so gebildete Anordnung im Einzelzug in mehreren Schritten auf Endmaß kalt umgeformt und danach das Hüllrohr entfernt wird. Hinsichtlich eines Halbzeugs liegt die Lösung der Aufgabe darin, daß die das Thermoelement bildenden Metalldrähte annähernd gleiche Umformfestigkeit aufweisen und das Metallrohr eine mindestens 1,5-fache höhere Umformfestigkeit als die Metalldrähte besitzt und daß das Metallrohr von einem Hüllrohr umgeben ist, dessen Umformfestigkeit im Bereich derjenigen des Metallrohres liegt.

Es hat sich herausgestellt, daß die mit dem erfindungsgemäßen Verfahren hergestellten Halbzeuge einen sehr gleichmäßigen Querschnitt der in der Keramik eingebetteten Thermodrähte zeigen, auch bei einem Außendurchmesser des Platin-Rhodium-Mantels von 0,3 mm, bei dem der Durchmesser der Thermodrähte bei etwa 0,05 bis 0,07 mm liegt. Derartige Thermoelemente zeigen außerdem über die Länge der Thermodrähte einen gleichbleibenden Querschnitt. Infolge der gleichförmigen Geometrie der Seelen sind keine Sollbruchstellen vorgegeben. Mit dem erfindungsgemäßen Verfahren können höhere Umformungsgrade bzw. kleinere Außendurchmesser gefertigt werden.

Ein zusätzliches Glühen nach Entfernen des Hüllrohres hat sich als vorteilhaft erwiesen, da durch diese zusätzliche Glühung ein spannungsfreies und gut biegefähiges Halbzeug erreicht wird. Für diese Glühung haben sich Temperaturen größer 900 °C als geeignet erwiesen.

...

Da die Materialwahl für die einzelnen Metalldrähte, das Metallrohr und das Hüllrohr hinsichtlich ihres Umformgrades entscheidend für den erzielbaren Durchmesser nach den Ziehschritten ist, sollte ein Platin-Rhodium-Draht mit mindestens einem Anteil von 10 bis 30 Gewichts-% Rhodium eingesetzt werden. Für das Metallrohr wird bevorzugt ein 10 bis 30 Gewichts-% Rhodium enthaltendes Rohr verwandt; gute Ergebnisse wurden auch mit einem Metallrohr aus Inconel erzielt.

Die Durchmesserreduzierung der Ausgangskonfiguration kann in einer Vielzahl von Ziehschritten erfolgen, wobei mit dem letzten Umformschritt das Metallrohr auf einen Außendurchmesser von mindestens 0,25 mm gezogen wird. Besonders gute Ergebnisse hinsichtlich der Gleichförmigkeit der Thermodrähte wurden erzielt beim Einsatz eines Metallrohres mit etwa 5 mm Außendurchmesser, in das der Keramikkörper mit den Thermodrähten eingesetzt wird. Mit den einzelnen Ziehschritten sollte bevorzugt der Querschnitt jeweils um etwa 10 % reduziert werden.

Nachfolgend werden zwei Beispiele in Verbindung mit der Zeichnung beschrieben, die bevorzugte Ausführungsformen darstellen.

## Beispiel 1:

Pt-PtRh10-Mantel-Thermoelement mit PtRh20-Mantel

Ausgangswerkstoffe

Keramik, MgO - porös mit zwei Kanälen (Kappilaren), Außendurchmesser 3,5 mm
Kapillarendurchmesser 0,7 mm
Länge 50 mm

Pt - Seele, Drahtdurchmesser 0,6 mm, hart gezogen, Härte 130 HV (HV = Härte Vickers)

...

00265582

PtRh10 - Seele, Durchmesser 0,6 mm, gering umgeformt Umformungsgrad = 10 %), Härte 160 HV

PtRh20 - Metallrohr, Außendurchmesser 4,6 mm Innendurchmesser 3,6 mm hart gezogen = 99 %, Härte 240 HV

Hüllrohr aus CuSn6, 30 % umgeformt, Härte 200 HV Außendurchmesser 6 mm Innendurchmesser 4 mm

Verfahren

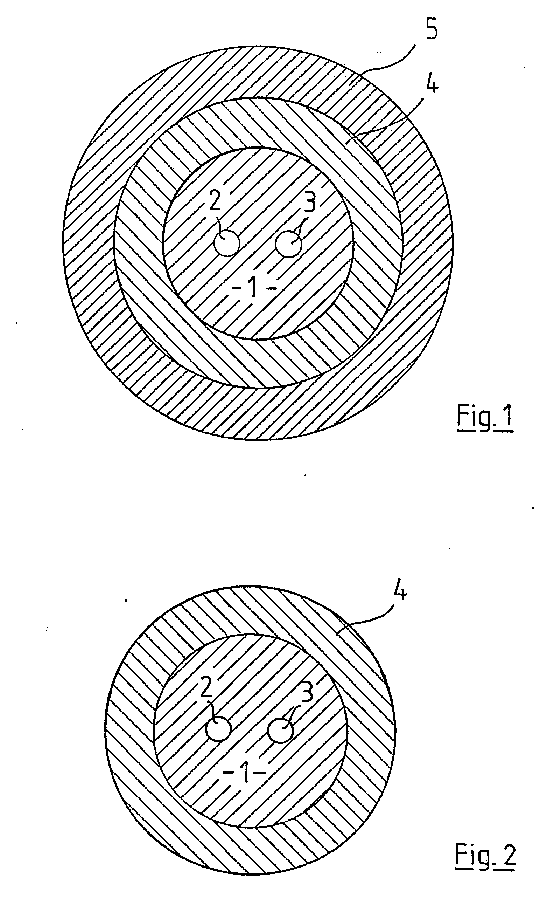

Nach dem Einziehen der Drähte in den Keramikkörper und dem Ummanteln in dem PtRh20-Metallrohr wird zunächst in einem Zug auf Durchmesser 4,49 mm gezogen. Anschließend wird auf 4,08 mm rund gehämmert. Danach von 4,08 mm auf 3,89 mm ziehen. Anschließend den Verbund in das CuSn6-Rohr einmanteln und auf 5,54 mm in einem Zug ziehen; bei allen weiteren Ziehfolgen beträgt die Abnahme zwischen den Stichen 9 %. Das Ziehen erfolgt im Einfachzug bis auf das gewünschte Endmaß bezüglich des PtRh20-Mantels. Der sich ergebende Aufbau ist im Querschnitt anhand der Figur 1 gezeigt. In ein Keramikrohr 1 sind in zwei Kapillaren ein Platin - Draht 2 und ein Platin-Rhodium10 - Draht 3 eingesezt. Das Keramikrohr 1 ist von einem Metallrohr 4 aus Platin-Rhodium20 umgeben, an dem ein Hüllrohr 5 aus CuSn6 anliegt. Der CuSn6-Mantel wird abgebeizt, so daß sich der in Figur 2 gezeigte Aufbau ergibt. Anschließend wird das Halbzeug einer Glühung unterzogen.

Beispiel 2:

Pt-PtRh10-Mantel-Thermoelement mit Inconel-Mantel

Verfahren, Werkstoffe und Abmessungen wie in Beispiel 1, jedoch wurde statt einem PtRh20-Metallrohr wurde ein Inconel-Metall mit einer Härte von 270 HV eingesetzt.

...

W. C. Heraeus GmbH


Patent- und Gebrauchsmusterhilfsanmeldung


"Manteldrahtthermoelement"


<u>Patentansprüche</u>


1. Verfahren zur Herstellung eines Halbzeuges für Mantelthermoelemente mit mindestens zwei ein Thermoelement bildenden Metalldrähten, wobei der eine Draht ein reiner Platindraht und der andere Draht ein Platin-Rhodium-Draht ist, die jeweils in eine Kapillare in einem Keramikkörper eingeführt werden, danach der Keramikkörper in ein Metallrohr gesteckt und diese Anordnung einer vorgegebenen Anzahl von Zieh- und/oder Gesenkschmiede-Schritten unterworfen wird, dadurch gekennzeichnet, daß als Metalldrähte Drähte mit annähernd gleicher Umformfestigkeit bereitgestellt werden und ein Metallrohr mit einer mindestens 1,5-fach höheren Umformfestigkeit als die der Metalldrähte verwendet wird, daß das Metallrohr mit dem eingesetzten, die Drähte aufweisenden Keramikkörper unter Erwärmen auf eine Temperatur bis zu 400 °C evakuiert, verschlossen und über das Metallrohr ein Hüllrohr gestülpt wird, dessen Umformfestigkeit beim Anliegen am Metallrohr im Bereich derjenigen des Metallrohres liegt, daß die so gebildete Anordnung im Einzelzug in mehreren Schritten auf Endmaß kalt umgeformt und danach das Hüllrohr entfernt wird.


2. Verfahren nach Anspruch 1, dadurch gekennzeichnet, daß nach Entfernen des Hüllrohres der umgeformte Verbund einer Glühung unterworfen wird.

00265582

3. Verfahren nach Anspruch 2, dadurch gekennzeichnet, daß die Glühung bei Temperaturen größer als 700 °C erfolgt.

4. Verfahren nach eienm der Ansprüche 1 bis 3, dadurch gekennzeichnet, daß der Platin-Rhodium-Draht mindestens einen Anteil von 10 bis 30 Gewichts-% Rhodium aufweist.

5. Verfahren nach Anspruch 4, dadurch gekennzeichnet, daß das Metallrohr ein Platin-Rhodium-Rohr mit einem Anteil von 10 bis 30 Gewichts-% Rhodium ist.

6. Verfahren nach einem der Ansprüche 1 bis 4, insbesondere nach Anspruch 4, dadurch gekennzeichnet, daß das Metallrohr ein Rohr aus Inconel ist.

7. Verfahren nach einem der Ansprüche 1 bis 6, dadurch gekennzeichnet, daß mit dem letzten Umformschritt das Metallrohr auf einen Außendurchmesser von mindestens 0,25 mm gezogen wird.

8. Verfahren nach einem der Ansprüche 1 bis 7, dadurch gekennzeichnet, daß der Außendurchmesser des verwendeten Metallrohres etwa 5 mm beträgt.

9. Verfahren nach einem der Ansprüche 1 bis 8, dadurch gekennzeichnet, daß die Umformung des Verbundes im Einzelzug in Ziehschritten unter Reduzierung des Querschnitts von jeweils etwa 10 % erfolgt.

10. Halbzeug für ein Mantelthermoelement mit einem Keramikkörper, mit zwei Kapillaren und darin eingesetzten Thermoelement-Drähten, wobei der eine Draht aus reinem Platin und der andere Draht der Platin-Rhodium-Draht ist und mit einem den Keramikkörper umgebenden Metallrohr, dadurch gekenn- zeichnet, daß die das Thermoelement bildenden Metalldrähte annähernd gleiche Umformfestigkeit aufweisen und das Metallrohr eine mindestens 1,5-fache höhere Umformfestigkeit als die Metalldrähte besitzt und daß das Metallrohr von einem Hüllrohr umgeben ist, dessen Umformfestigkeit im Bereich derjenigen des Metallrohres liegt.

...

Fig. 1

Fig. 2

# EUROPÄISCHER RECHERCHENBERICHT

**Europäisches Patentamt**

## EINSCHLÄGIGE DOKUMENTE

EP 87105443.3

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | VDI BERICHTE, Nr. 112, 1966, Düsseldorf<br><br>T.SANNES "Mantel-Thermoelemente"<br>Seiten 95-102<br><br>  * Seiten 95,96 *<br><br>    -- | 1,5-8 | H 01 L 35/34<br>H 01 L 35/02<br>G 01 K 7/04 |
| A | F.X.EDER "Arbeitsmethoden der Thermodynamik, Band 1, Temperaturmessung" 1981<br>SPRINGER-VERLAG, Berlin<br>Seiten 54-61<br><br>  * Seiten 54,55; Seite 61,<br>    Bild 2.18.b *<br><br>    -- | 1,5,10 | |
| A | US - A - 4 485 263 (ITOYAMA et al.)<br><br>  * Gesamt; insbesondere Fig. 1 *<br><br>    ---- | 1 | |

**RECHERCHIERTE SACHGEBIETE (Int. Cl.4)**

H 01 L 35/00
G 01 K 7/00

Der vorliegende Recherchenbericht wurde für alle Patentansprüche erstellt.

| Recherchenort | Abschlußdatum der Recherche | Prüfer |
|---|---|---|
| WIEN | 19-01-1988 | BURGHARDT |